# EUROPÄISCHE PATENTSCHRIFT

(11) **EP 3 608 048 B1**
(45) Veröffentlichungstag und Bekanntmachung des Hinweises auf die Patenterteilung: **28.04.2021**
(21) Anmeldenummer: 19201099.9
(22) Anmeldetag: 08.10.2014
(51) Int. Cl.: B23K 26/00, B28D 5/00, B23K 26/53, H01L 21/268, H01L 31/18, H01L 21/78, B23K 101/40, B23K 103/00

(54) **HERSTELLUNGSVERFAHREN FÜR FESTKÖRPERELEMENTE MITTELS LASERBEHANDLUNG UND TEMPERATURINDUZIERTEN SPANNUNGEN**
METHOD OF PRODUCING SOLID ELEMENTS BY LASER TREATMENT AND TEMPERATURE INDUCED STRESSES
PROCÉDÉ DE FABRICATION D'ÉLÉMENTS DE CORPS SOLIDE AU MOYEN DU TRAITEMENT LASER ET DE CONTRAINTES INDUITES PAR LA TEMPÉRATURE

(30) Priorität: 08.10.2013 DE 102013016693
(43) Veröffentlichungstag der Anmeldung: 12.02.2020
(62) Teilanmeldung aus: 14790526.9
(73) Patentinhaber: Siltectra GmbH, 01099 Dresden (DE)
(72) Erfinder: DRESCHER, Wolfram, 01109 Dresden (DE); RICHTER, Jan, 01277 Dresden (DE)
(74) Vertreter: Müller Hoffmann & Partner

(56) Entgegenhaltungen:
- EP-A1- 1 498 216
- EP-A1- 2 218 539
- WO-A2-2009/061353
- JP-A- 2006 245 498
- JP-A- 2010 184 457

## Beschreibung

Die vorliegende Erfindung bezieht sich auf ein Verfahren zum Herstellen von Festkörperelementen gemäß dem Oberbegriff des Anspruchs 1 (siehe z.B. JP 2006 245498 A).

In vielen technischen Bereichen (z.B. Mikroelektronik- oder Photovoltaiktechnologie) werden Materialien, wie z.B. Silizium, Germanium oder Saphir, häufig in der Form dünner Scheiben und Platten (so genannte Wafer) gebraucht. Standardmäßig werden solche Wafer derzeit durch Sägen aus einem Ingot hergestellt, wobei relativ große Materialverluste ("kerf-loss") entstehen. Da das verwendete Ausgangsmaterial oft sehr teuer ist, gibt es starke Bestrebungen, solche Wafer mit weniger Materialaufwand und damit effizienter und kostengünstiger herzustellen.

Beispielsweise gehen mit den derzeit üblichen Verfahren allein bei der Herstellung von Siliziumwafer für Solarzellen fast 50% des eingesetzten Materials als "kerf-loss" verloren. Weltweit gesehen entspricht dies einem jährlichen Verlust von über 2 Milliarden Euro. Da die Kosten des Wafers den größten Anteil an den Kosten der fertigen Solarzelle ausmachen (über 40%), könnten durch entsprechende Verbesserungen der Waferherstellung die Kosten von Solarzellen signifikant reduziert werden.

Besonders attraktiv für eine solche Waferherstellung ohne kerf-loss ("kerf-free wafering") erscheinen Verfahren, die auf das herkömmliche Sägen verzichten und z.B. durch Einsatz von temperaturinduzierten Spannungen direkt dünne Wafer von einem dickeren Werkstück abspalten können. Dazu gehören insbesondere Verfahren, wie sie z.B. in PCT/US2008/012140 und PCT/EP2009/067539 beschrieben sind, wo zum Erzeugen dieser Spannungen eine auf das Werkstück aufgetragene Polymerschicht verwendet wird.

Die Druckschrift EP 2 218 539 A1 beschreibt das Vereinzeln von Halbeiterchips. Durch Beaufschlagung mit Laserstrahlung werden in einem Substrat in einem Fokusbereich der Laserstrahlung Rissgebiete erzeugt. Die Rissgebiete bilden ein gitterförmiges Schneidemuster (cutting pattern) entlang dessen Gitterlinien die Halbleiterchips durch Induzieren mechanischer Spannung vereinzelt werden. Die Druckschrift JP 2010 184 457 A beschreibt ebenfalls das Ausbilden von zueinander orthogonalen Schreiblinien entlang derer ein Substrat in eine Vielzahl kleinerer Substratbereiche geteilt wird. Die Druckschrift EP 1 498 216 A1 beschreibt das Bestrahlen eines Siliziumwafers mit einem Laser entlang von Schnittlinien und das Teilen des Siliziumwafers in Halbleiterchips entlang der zu einem Gitter angeordneten, geraden Schnittlinien.

Die Polymerschicht weist bei den erwähnten Verfahren einen im Vergleich zum Werkstück um ungefähr zwei Größenordnungen höheren thermischen Ausdehnungskoeffizienten auf. Außerdem kann durch Ausnutzen eines Glasübergangs ein relativ hoher Elastizitätsmodul in der Polymerschicht erreicht werden, so dass im Schichtsystem Polymerschicht-Werkstück durch Abkühlen genügend große Spannungen induziert werden können, um die Abspaltung eines Wafers vom Werkstück zu ermöglichen.

Beim Abspalten eines Wafers vom Werkstück haftet bei den erwähnten Verfahren jeweils auf einer Seite des Wafers noch Polymer an. Der Wafer krümmt sich dabei sehr stark in Richtung dieser Polymerschicht, was ein kontrolliertes Abspalten erschwert, und z.B. zu Dickenschwankungen des abgespaltenen Wafers führen kann. Außerdem erschwert die starke Krümmung die weitere Verarbeitung und kann sogar zum Zerbrechen des Wafers führen.

Bei Verwendung der Verfahren nach bisherigem Stand der Technik weisen die hergestellten Wafer üblicherweise jeweils größere Dickenschwankungen auf, wobei die räumliche Dickenverteilung häufig ein Muster mit vierzähliger Symmetrie zeigt. Die totale Dickenschwankung über den ganzen Wafer gesehen ("total thickness Variation", TTV) beträgt bei Verwendung der bisherigen Verfahren häufig mehr als 100% der mittleren Waferdicke (ein Wafer von bspw. 100 Mikrometer mittlerer Dicke, der z.B. an seiner dünnsten Stelle 50 Mikrometer dick und an seiner dicksten Stelle 170 Mikrometer dick ist, hat ein TTV von 170-50=120 Mikrometer, was relativ zu seiner mittleren Dicke einer totalen Dickenschwankung von 120% entspricht). Wafer mit solch starken Dickenschwankungen sind für viele Anwendungen nicht geeignet. Außerdem liegen bei den am häufigsten auftretenden vierzähligen Dickenverteilungsmustern die Bereiche mit den größten Schwankungen unglücklicherweise in der Mitte des Wafers, wo sie am meisten stören.

Außerdem entstehen beim Verfahren nach aktuellem Stand der Technik während der Bruchpropagation beim Abspalten selbst unerwünschte Oszillationen in den beteiligten Schichtsystemen, die den Verlauf der Bruchfront ungünstig beeinflussen und insbesondere zu signifikanten Dickenschwankungen des abgespaltenen Wafers führen können.

Zudem ist es bei den bisherigen Verfahren schwierig, einen reproduzierbar guten Wärmekontakt über die ganze Fläche der Polymerschicht sicherzustellen. Lokal ungenügender Wärmekontakt kann aber aufgrund der geringen thermischen Leitfähigkeit der verwendeten Polymere zu ungewollten, signifikanten lokalen Temperaturabweichungen im Schichtsystem führen, was sich seinerseits negativ auf die Kontrollierbarkeit der erzeugten Spannungsfelder und damit die Qualität der hergestellten Wafer auswirkt.

Weiterhin ist aus der Druckschrift DE 196 40 594 A1 ein Verfahren zur Trennung von Halbleitermaterialien mittels licht-induzierter Grenzflächenzersetzung und damit hergestellter Vorrichtungen, wie strukturierte und freistehende Halbleiterschichten und Bauelemente, bekannt. Das Verfahren gemäß der DE 196 40 594 A1 beinhaltet die Beleuchtung von Grenzflächen zwischen Substrat und Halbleiterschicht oder zwischen Halbleiterschichten, wodurch die Lichtabsorption an der Grenzfläche oder in einer dafür vorgesehenen Absorptionsschicht zur Materialzersetzung führt. Die Auswahl der Grenzfläche oder Halbleiterschicht, welche zur Zersetzung gebracht wird, erfolgt durch die Wahl der Lichtwellenlänge und Lichtintensität, die Einstrahlrichtung oder den Einbau einer dünnen Opferschicht während der Materialherstellung. Dieses Verfahren hat den Nachteil, dass zur Zerstörung ganzer Schichten hohe Energiedosen verwendet werden müssen, wodurch der Energiebedarf und somit die Kosten des Verfahrens sehr hoch sind.

Ferner werden die erzeugten Festkörperschichten nach all diesen Verfahren noch in einzelne Festkörperelemente zersägt, wodurch wiederum ein hoher Materialverlust entsteht.

Es ist somit die Aufgabe der vorliegenden Erfindung ein kostengünstiges Verfahren zur Herstellung von Festkörperelementen, insbesondere Computerchips, mit einer gleichmäßigen Dicke, insbesondere mit einem TTV von weniger als 120 Mikrometer, bereitzustellen.

Die zuvor genannte Aufgabe wird durch ein Verfahren zum Herstellen von Festkörperelementen gemäß Anspruch 1 gelöst. Ein solches Verfahren zum Herstellen von Festkörperelementen, insbesondere von Trägerelementen zum Aufnehmen von elektrisch leitfähigen Komponenten umfasst bevorzugt mindestens die Schritte, des Bereitstellens eines Festkörpers, insbesondere eines dicken Wafers, zum Abspalten mindestens einer Festkörperschicht, insbesondere eines dünnen Wafers, des Erzeugens einer ersten Gruppe von Defekten mittels eines Lasers zum Vorgeben einer ersten Ablöseebene, entlang der die Festkörperschicht vom Festkörper abgetrennt wird, des Erzeugens einer zweiten Gruppe von Defekten mittels des Lasers zum Vorgeben von mindestens einer zweiten Ablöseebene, wobei die erste Ablöseebene und die zweite Ablöseebene zueinander orthogonal ausgerichtet sind, des Ablösens der Festkörperschicht vom Festkörper entlang der ersten Ablöseebene infolge einer Erzeugung von Spannungen in dem Festkörper und des Teilens der Festkörperschicht entlang der zweiten Ablöseebene zum Vereinzeln der Festkörperelemente.

Dieses Verfahren ist vorteilhaft, da durch die Defekterzeugung in mehreren zueinander orthogonalen Ebenen ohne signifikanten Materialverlust eine definierte Schwächung der Festkörperstruktur bzw. der Festkörperschichtstruktur bewirkt wird, wodurch auf vorteilhafte Weise Sollbruchstellen definiert werden, entlang denen ein mittels Spannungen induzierter Riss führbar ist.

Weitere Ausführungsformen sind Gegenstand der Unteransprüche und der nachfolgenden Beschreibung.

Gemäß einer bevorzugten Ausführungsform der vorliegenden Erfindung wird mindestens eine dritte Gruppe an Defekten zum Vorgeben mindestens einer und bevorzugt mehrerer dritter Ablöseebenen mittels des Lasers erzeugt, wobei die und bevorzugt jede dritte Ablöseebene orthogonal zur ersten Ablöseebene und orthogonal zur zweiten bzw. zu einer zweiten Ablöseebene ausgerichtet ist, wobei die Festkörperschicht zum Vereinzeln der Festkörperelemente entlang der zweiten Ablöseebene und entlang der dritten Ablöseebene voneinander getrennt werden. Bevorzugt werden mehrere dritte Ablöseebenen erzeugt, die im Zusammenspiel mit mehreren zweiten Ablöseebenen ein bevorzugt gitterförmiges Muster bilden, das die einzelnen Festkörperelemente, die den Festkörper bilden bzw. mit ausbilden voneinander abgrenzt. Diese Ausführungsform ist vorteilhaft, da das gitterförmige Muster eine gitterförmige Sollbruchstelle darstellt, entlang der die Vielzahl der einzelnen Festkörperelemente auf einfache und definierte Art voneinander getrennt werden können.

Die Spannungen zum Ablösen der Festkörperschicht werden gemäß einer weiteren bevorzugten Ausführungsform der vorliegenden Erfindung von dem Festkörper durch die thermische Beaufschlagung mindestens einer am Festkörper angeordneten Aufnahmeschicht, insbesondere einer Polymerschicht, erzeugt. Die thermische Beaufschlagung stellt bevorzugt ein Abkühlen der Aufnahmeschicht bzw. Polymerschicht auf oder unter die Umgebungstemperatur und bevorzugt unter 10°C und besonders bevorzugt unter 0°C und weiter bevorzugt unter -10°C dar. Die Abkühlung der Polymerschicht erfolgt höchst bevorzugt derart, dass zumindest ein Teil der Polymerschicht, die bevorzugt aus PDMS besteht, einen Glasübergang vollzieht. Die Abkühlung kann hierbei eine Abkühlung auf unter -100°C sein, die z.B. mittels flüssigen Stickstoffs bewirkbar ist. Diese Ausführungsform ist vorteilhaft, da sich die Polymerschicht in Abhängigkeit von der Temperaturveränderung zusammenzieht und/oder einen Gasübergang erfährt und die dabei entstehenden Kräfte auf den Festkörper überträgt, wodurch mechanische Spannungen in dem Festkörper erzeugbar sind, die zum Auslösen eines Risses und/oder zur Rissausbreitung führen, wobei sich der Riss zunächst entlang der ersten Ablöseebene zum Abspalten der Festkörperschicht ausbreitet.

Die Polymerschicht, insbesondere PDMS, wird gemäß einer weiteren bevorzugten Ausführungsform der vorliegenden Erfindung zum Erzeugen der Spannungen definiert abgekühlt, wobei die Spannungen in dem Festkörper derart erzeugbar sind, dass die Rissauslösung und/oder die Rissausbreitung zum Erzeugen einer vorbestimmten Oberflächenbeschaffenheit der sich in der Rissebene ergebenden Oberfläche steuerbar ist. Diese Ausführungsform ist vorteilhaft, da aufgrund des beeinflussbaren bzw. steuerbaren Rissverlaufs Bereiche, in denen der Riss typischerweise eine eher heterogene Oberfläche, d.h. mit einer hohen Dickenschwankung hinterlässt, reduzierbar sind bzw. derart z.B. an den Rand des Festkörpers verlagerbar sind, dass die Gesamtzahl der nutzbaren Festkörperelemente erhöht wird.

Die Polymerschicht wird gemäß einer weiteren bevorzugten Ausführungsform der vorliegenden Erfindung derart beaufschlagt, dass sie eine Formveränderung in einer ersten Richtung und/oder in einer zweiten Richtung erfährt, wobei eine Formveränderung in der ersten Richtung ein Ablösen von Festkörperelementen voneinander entlang der zweiten Ablöseebene bewirkt und eine Formveränderung in der zweiten Richtung ein Ablösen von Festkörperelementen voneinander entlang der dritten Ablöseebene bewirkt. Diese Ausführungsform ist vorteilhaft, da die ohnehin schon an der abgetrennten Festkörperschicht angeordnete bzw. anhaftende Polymerschicht nicht nur zur Abtrennung der Festkörperschicht von dem Festkörper und zur Aufnahme der abgetrennten Festkörperschicht dient, sondern noch zur Vereinzelung der Festkörperelemente verwendet wird. Dies stellt somit eine deutliche Prozessvereinfachung und eine deutliche Prozessbeschleunigung dar, wodurch die einzelnen Festkörperelemente deutlich günstiger und schneller hergestellt werden können.

Die Formveränderung der Polymerschicht stellt gemäß einer weiteren bevorzugten Ausführungsform der vorliegenden Erfindung in der ersten Richtung und/oder in der zweiten Richtung eine radiale Ausdehnung dar, die infolge einer mechanischen Belastung und/oder einer thermischen Beaufschlagung bewirkt wird. Die Polymerschicht kann somit bevorzugt auf verschiedene Arten in ihrer Form verändert werden, wodurch eine hohe Prozessflexibilität geschaffen wird. Bevorzugt wird die Polymerschicht in eine oder mehrere Richtungen gezogen, gedrückt und/oder gebogen. Zusätzlich oder alternativ ist jedoch ebenfalls denkbar, dass die Polymerschicht derart temperiert wird, dass sie sich ausdehnt.

Der Festkörper weist bevorzugt ein Material oder eine Materialkombination aus einer der Hauptgruppen 3, 4 und 5 des Periodensystems der Elemente auf, wie z.B. Si, SiC, SiGe, Ge, GaAs, InP, GaN, Al2O3 (Saphir), AIN. Besonders bevorzugt weist der Festkörper eine Kombination aus in der dritten und fünften Gruppe des Periodensystems vorkommenden Elementen auf. Denkbare Materialien oder Materialkombinationen sind dabei z.B. Galliumarsenid, Silizium, Siliziumcarbid, etc. Weiterhin kann der Festkörper eine Keramik (z.B. Al2O3 - Alumiumoxid) aufweisen oder aus einer Keramik bestehen, bevorzugte Keramiken sind dabei z.B. Perovskitkeramiken (wie z.B. Pb-, O-, Ti/Zr-haltige Keramiken) im Allgemeinen und Blei-Magnesium-Niobate, Bariumtitanat, Lithiumtitanat, Yttrium-Aluminium-Granat, insbesondere Yttrium-Aluminium-Granat Kristalle für Festkörperlaseranwendungen, SAW-Keramiken (surface acoustic wave), wie z.B. Lithiumniobat, Galliumorthophosphat, Quartz, Calziumtitanat, etc. im Speziellen. Der Festkörper weist somit bevorzugt ein Halbleitermaterial oder ein Keramikmaterial auf bzw. besonders bevorzugt besteht der Festkörper aus mindestens einem Halbleitermaterial oder einem Keramikmaterial. Es ist weiterhin denkbar, dass der Festkörper ein transparentes Material aufweist oder teilweise aus einem transparenten Material, wie z.B. Saphir, besteht bzw. gefertigt ist. Weitere Materialien, die hierbei als Festkörpermaterial alleine oder in Kombination mit einem anderen Material in Frage kommen, sind z.B. "wide band gap"-Materialien, InAISb, Hochtemperatursupraleiter, insbesondere seltene Erden Cuprate (z.B. YBa2Cu3O7).

Die erste Gruppe von Defekten und die zweite Gruppe von Defekten werden gemäß einer weiteren Ausführungsform der vorliegenden Erfindung vor dem Ablösen der Festkörperschicht von dem Festkörper in dem Festkörper erzeugt. Diese Ausführungsform ist vorteilhaft, da die abgetrennte Festkörperschicht, dann nicht nochmal mit einem Laser behandelt werden muss, sondern direkt weiter verarbeitet werden kann bzw. die Festkörperelemente vereinzelt werden können.

Die zweite Gruppe und bevorzugt die dritte Gruppe von Defekten werden gemäß einer weiteren bevorzugten Ausführungsform der vorliegenden Erfindung nach dem Ablösen der Festkörperschicht von dem Festkörper erzeugt. Diese Ausführungsform ist vorteilhaft, da keine Gefahr einer Beeinflussung der Rissführung zum Abtrennen der Festkörperschicht durch die Defekte der zweiten und/oder dritten Gruppe besteht.

Weitere Vorteile, Ziele und Eigenschaften der vorliegenden Erfindung werden anhand nachfolgender Beschreibung anliegender Zeichnungen erläutert, in welchen beispielhaft die erfindungsgemäße Waferherstellung dargestellt ist. Bauteile oder Elemente der erfindungsgemäßen Waferherstellung, welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Einzelne oder alle Darstellungen der im Nachfolgenden beschriebenen Figuren sind bevorzugt als Konstruktionszeichnungen anzusehen, d.h. die sich aus der bzw. den Figuren ergebenden Abmessungen, Proportionen, Funktionszusammenhänge und/oder Anordnungen entsprechen bevorzugt genau oder bevorzugt im Wesentlichen denen der erfindungsgemäßen Vorrichtung bzw. des erfindungsgemäßen Produkts.

Darin zeigen:
- Fig. 1a: einen schematischen Aufbau zum Erzeugen von Defekten in einem Festkörper;
- Fig. 1b: eine schematische Darstellung einer Schichtanordnung vor dem Abtrennen einer Festkörperschicht von einem Festkörper;
- Fig. 1c: eine schematische Darstellung einer Schichtanordnung nach dem Abtrennen einer Festkörperschicht von einem Festkörper;
- Fig. 2a: eine erste schematisch dargestellte Variante zur Defekterzeugung mittels Lichtwellen;
- Fig. 2b: eine zweite schematisch dargestellte Variante zur Defekterzeugung mittels Lichtwellen;
- Fig. 3a: zeigt eine schematisch Draufsicht und eine schematische Seitenansicht des Festkörpers;
- Fig. 3b: zeigt die Darstellung der Fig. 3a und eine schematische Darstellung einer ersten Ablöseebene;
- Fig. 4: zeigt schematisch eine weitere Anordnung der die Ablöseebenen definierenden Defekte;
- Fig. 5a: zeigt ein schematisches Beispiel der Ausbildung mehrerer zweiter Ablöseebenen;
- Fig. 5b: zeigt ein weiteres schematisches Beispiel bzgl. der Ausbildung der zweiten Ablöseebenen und der dritten Ablöseebenen;
- Fig. 6: zeigt eine Festkörperschicht mit zweiten Ablöseebenen, die an einer Polymerschicht angeordnet ist;
- Fig. 7a: zeigt eine Festkörperschicht vor der Zerteilung in Festkörperelemente; und
- Fig. 7b: zeigt eine Festkörperschicht nach der Zerteilung in Festkörperelemente.

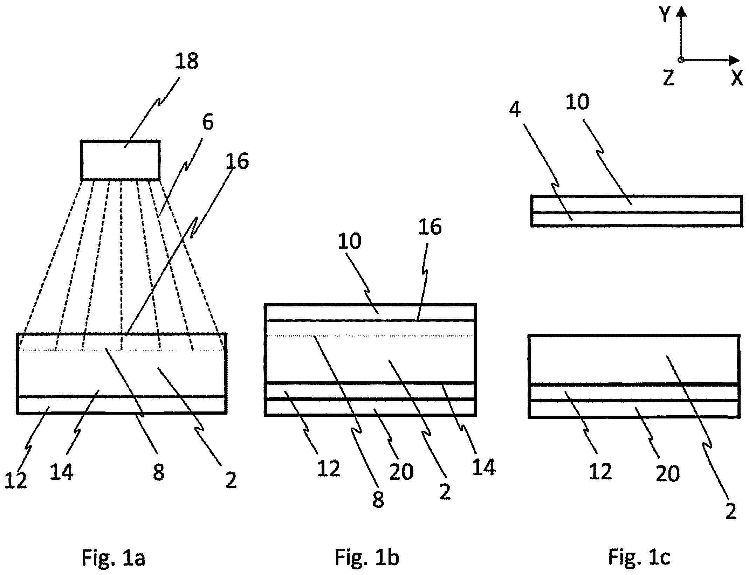

In Fig. 1a ist ein Festkörper 2 bzw. ein Substrat gezeigt, das im Bereich einer Strahlungsquelle 18, insbesondere einem Laser, angeordnet ist. Der Festkörper 2 weist bevorzugt einen ersten ebenen Flächenanteil 14 und einen zweiten ebenen Flächenanteil 16 auf, wobei der erste ebene Flächenanteil 14 bevorzugt im Wesentlichen oder genau parallel zu dem zweiten ebenen Flächenanteil 16 ausgerichtet ist. Der erste ebene Flächenanteil 14 und der zweite ebene Flächenanteil 16 begrenzen bevorzugt den Festkörper 2 in einer Y-Richtung, die bevorzugt vertikal bzw. lotrecht ausgerichtet ist. Die ebenen Flächenanteile 14 und 16 erstrecken sich bevorzugt jeweils in einer X-Z-Ebene, wobei die X-Z-Ebene bevorzugt horizontal ausgerichtet ist. Weiterhin lässt sich dieser Darstellung entnehmen, dass die Strahlungsquelle 18 Stahlen 6 auf den Festkörper 2 ausstrahlt. Die Strahlen 6 dringen je nach Konfiguration definiert tief in den Festkörper 2 ein und erzeugen an der jeweiligen Position bzw. an einer vorbestimmten Position einen Defekt.

In Fig. 1b ist eine mehrschichtige Anordnung gezeigt, wobei der Festkörper 2 die Ablöseebene 8 beinhaltet und im Bereich des ersten ebenen Flächenanteils 14 mit einer Halteschicht 12 versehen ist, die wiederum bevorzugt von einer weiteren Schicht 20 überlagert wird, wobei die weitere Schicht 20 bevorzugt eine Stabilisierungseinrichtung, insbesondere eine Metallplatte, ist. An dem zweiten ebenen Flächenanteil 16 des Festkörpers 2 ist bevorzugt eine Polymerschicht 10 angeordnet. Die Polymerschicht 10 und/oder die Halteschicht 12 bestehen bevorzugt zumindest teilweise und besonders bevorzugt vollständig aus PDMS.

In Fig. 1c ist ein Zustand nach einer Rissauslösung und anschließender Rissführung gezeigt. Die Festkörperschicht 4 haftet an der Polymerschicht 10 und ist von dem verbleibenden Rest des Festkörpers 2 beabstandet bzw. beabstandbar.

Die Erfindung bezieht sich somit auf ein Verfahren zum Herstellen von Festkörperelementen 40, insbesondere Trägerelementen zum Aufnehmen von elektrisch leitfähigen Komponenten. Das Verfahren umfasst mindestens die Schritte: Bereitstellen eines Festkörpers 2 zum Abspalten mindestens einer Festkörperschicht 4, Erzeugen einer ersten Gruppe von Defekten mittels eines Lasers 18 zum Vorgeben einer ersten Ablöseebene 8, entlang der die Festkörperschicht 4 vom Festkörper 2 abgetrennt wird, Erzeugen einer zweiten Gruppe von Defekten mittels des Lasers 18 zum Vorgeben von mindestens einer zweiten Ablöseebene 50, wobei die erste Ablöseebene 8 und die zweite Ablöseebene 8 zueinander orthogonal ausgerichtet sind, Ablösen der Festkörperschicht 4 vom Festkörper 2 entlang der ersten Ablöseebene 8 infolge einer Erzeugung von Spannungen in dem Festkörper 2 und Teilen der Festkörperschicht 4 entlang der zweiten Ablöseebene 50 zum Vereinzeln der Festkörperelemente 40.

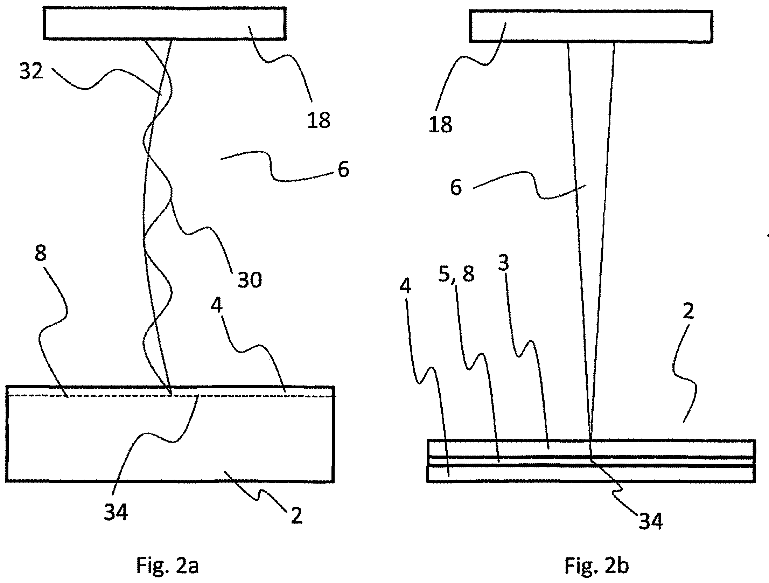

In den Figuren 2a und 2b sind Beispiele für die in Fig. 1a gezeigte Erzeugung einer Ablöseebene 8 durch die Einbringung von Defekten in einen Festkörper 2 mittels Lichtstrahlen gezeigt.

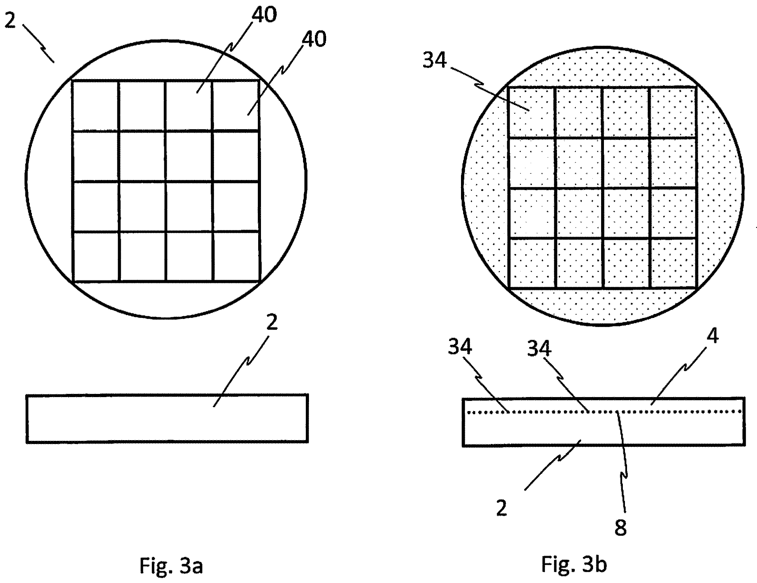

In Fig. 2a ist somit schematisch gezeigt, wie Defekte in einem Festkörper 2, insbesondere zur Erzeugung von Ablöseebenen, insbesondere einer oder mehrerer Ablöseebene/n 8, einer oder mehrerer zweiter Ablöseebene/n 50 (vgl. Fig. 3a) und/oder einer oder mehrerer dritter Ablöseebenen 52 (vgl. Fig. 3b), mittels einer Strahlungsquelle 18, insbesondere einem oder mehrerer Laser, erzeugbar ist. Die Strahlungsquelle 18 emittiert dabei gemäß einer ersten Defekterzeugungsvariante Strahlung 6 mit einer ersten Wellenlänge 30 und einer zweiten Wellenlänge 32. Die Wellenlängen 30, 32 sind dabei derart aufeinander abgestimmt bzw. die Distanz zwischen der Strahlungsquelle 18 und der zu erzeugenden Ablöseebene 8 ist derart abgestimmt, dass die Wellen 30, 32 im Wesentlichen oder genau auf der Ablöseebene 8 in dem Festkörper 2 zusammentreffen, wodurch am Ort des Zusammentreffens 34 infolge der Energien beider Wellen 30, 32 ein Defekt erzeugt wird. Die Defekterzeugung kann dabei durch unterschiedliche oder kombinierte Zersetzungsmechanismen wie z.B. Sublimation oder chemische Reaktion erfolgen, wobei die Zersetzung dabei z.B. thermisch und/oder photochemisch initiiert werden kann.

In Fig. 2b ist ein fokussierter Lichtstrahl 6 gezeigt, dessen Brennpunkt bevorzugt in der zu erzeugenden ersten Ablöseebene 8 (oder zweiten Ablöseebene 50, dritten Ablöseebene 52 vgl. Fig. 3a und 3b) liegt. Es ist hierbei denkbar, dass der Lichtstrahl 6 durch einen oder mehrere fokussierende Körper, insbesondere Linse/n (nicht gezeigt), fokussiert wird. Der Festkörper 2 ist in dieser Ausführungsform mehrschichtig ausgebildet und weist bevorzugt eine teiltransparente oder transparente Substratschicht 3 bzw. Materialschicht auf, die bevorzugt aus Saphir besteht oder Saphir aufweist. Die Lichtstrahlen 6 gelangen durch die Substratschicht 3 z.B. auf die Position der ersten Ablöseebene 8, die bevorzugt durch eine Opferschicht 5 gebildet wird, wobei die Opferschicht 5 durch die Strahlung derart beaufschlagt wird, dass thermisch und/oder photochemisch eine teilweise oder vollständige Zerstörung der Opferschicht 5 in dem Brennpunkt bzw. im Bereich des Brennpunkts bewirkt wird. Es ist ebenfalls denkbar, dass die Defekte zur Erzeugung einer Ablöseschicht bzw. der ersten Ablöseschicht 8 im Bereich oder genau auf einer Grenzfläche zwischen zwei Schichten 3, 4 erzeugt werden. Somit ist ebenfalls denkbar, dass die Festkörperschicht 4 auf einer Trägerschicht, insbesondere einer Substratschicht 3, erzeugt wird und mittels einer oder mehrerer Opferschichten 5 und/oder mittels der Erzeugung von Defekten in einer Grenzfläche, insbesondere zwischen der Festkörperschicht 4 und der Trägerschicht, eine Ablöseebene 8 zum Ablösen bzw. Abtrennen der Festkörperschicht 4 erzeugbar ist.

In Fig. 3a ist schematisch im oberen Bildteil eine Draufsicht auf einen Festkörper 2 gezeigt und im unteren Bildteil ist eine Seitenansicht, insbesondere eine Schnittdarstellung. gezeigt. Der Festkörper 2 ist in dieser Darstellung mit geraden Linien versehen, welche die einzelne aneinander angeordnete Festkörperelemente 40, insbesondere Trägerelemente, wie z.B. Computerchips oder Solarzellen, begrenzen. Die Linien können hierbei rein exemplarisch und zu Erläuterungszwecken die äußere Form der Festkörperelemente 40 beschreiben, wobei sie bei einem realen Festkörper 2 nicht oder nicht zwingend ersichtlich bzw. vorhanden sein müssen. Ferner kann der Festkörper 2 in der Draufsicht eine andere äußere Form, insbesondere mit geraden Anteilen, aufweisen.

In Fig. 3b sind der Draufsicht und der Seitenansicht jeweils eine Vielzahl an Defekte 34 zu entnehmen. Die Defekte 34 können, wie z.B. in der Draufsicht dargestellt, gleichmäßig verteilt sein oder in bestimmten Bereichen vermehrt bzw. vermindert erzeugt werden. Eine hohe Konzentration an Defekten 34 gegenüber einer geringen Konzentration an Defekten 34 ermöglicht z.B. eine definierte Rissauslösung und/oder ein einfacheres Ablösen der Festkörperschicht 4 in dem jeweiligen Bereich. Bevorzugt ist im Bereich einer Stelle des Festkörpers 2, an der ein Riss ausgelöst werden soll, eine erhöhte Konzentration an Defekten 34 vorgesehen. Weiterhin werden bevorzugt zur Steuerung des Rissverlaufs Defekte 34 in einer erhöhten Konzentration vorgegebenen, um die Rissausbreitung zu lenken. Weiterhin wird bevorzugt in der Mitte bzw. im Zentrum der ersten Ablöseebene 8 zusätzlich oder alternativ eine gegenüber anderen Bereichen der ersten Ablöseschicht 8 erhöhte Konzentration an Defekten 34 erzeugt. Es lässt sich der Seitenansicht entnehmen, dass die Ablöseebene 8 bevorzugt durch in einer Ebene erzeugte Defekte 34 gebildet wird.

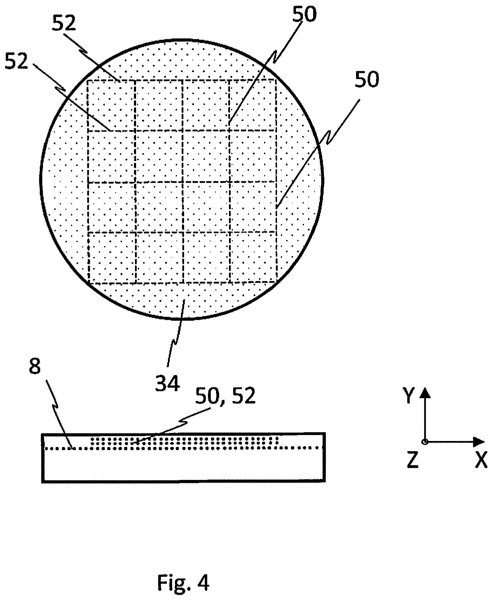

Die Draufsicht der Fig. 4 zeigt neben den Defekten 34, welche die erste Ablöseschicht 8 bilden, weitere in zweiten Ablöseebenen 50 erzeugte Defekte, die mittels gestrichelten Linien dargestellt sind und sich in Z-Richtung erstrecken. Weiterhin sind in X-Richtung orientierte gestrichelte Linien gezeigt, die ebenfalls Defekte repräsentieren und in dritten Ablöseebenen 52 liegen. Die erste Ablöseebene 8 liegt somit bevorzugt in der X-Z-Ebene, die zweite Ablöseebene 50 liegt bevorzugt in der Y-Z-Ebene und die dritte Ablöseebene 52 liegt bevorzugt in der x-Y-Ebene. Der Seitenansicht bzw. Schnittdarstellung der Fig. 4 lässt sich entnehmen, dass die Defekte, d.h. Defekte die zum Erzeugen der ersten Ablöseschicht 8 und die Defekte zum Erzeugen der zweiten Ablöseschicht 50 sowie der dritten Ablöseschicht 52 gegenüber einer ebenen Oberfläche des Festkörpers 2, insbesondere gegenüber einer in einer X-Z-Ebene liegenden Oberfläche des Festkörpers 2, unterschiedlich weit beabstandet sind.

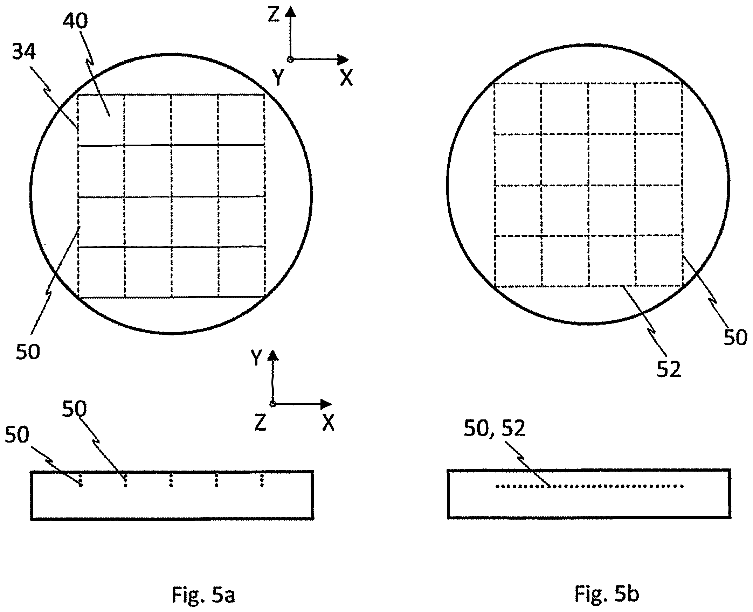

In Fig. 5a ist eine Draufsicht gezeigt, gemäß der die Defekte 34 zum Erzeugen der zweiten Ablöseebene/n 50 bereits erzeugt sind. Die Defekte 34 zum Ausbilden der dritten Ablöseebene/n 52 sind jedoch noch nicht erzeugt. Es ist somit denkbar, dass die Defekte zum Erzeugen der zweiten und dritten Ablöseebene/n 50, 52 zeitgleich, zeitversetzt oder vollständig nacheinander erzeugt werden. Weiterhin ist der Seitenansicht bzw. Schnittdarstellung zu entnehmen, dass die Defekte zum Erzeugen der zweiten Ablöseebene/n 50 mit unterschiedlichen Abständen zu einer sich in der X-Z-Ebene erstreckenden Oberfläche erzeugt werden können.

Fig. 5b lässt sich entnehmen, dass die Defekte zum Erzeugen der ersten Ablöseschicht 50 und der zweiten Ablöseschicht 52 in ihrer Gesamtheit auch mit demselben Abstand zu einer sich in der X-Z-Ebene erstreckenden Oberfläche erzeugt werden können.

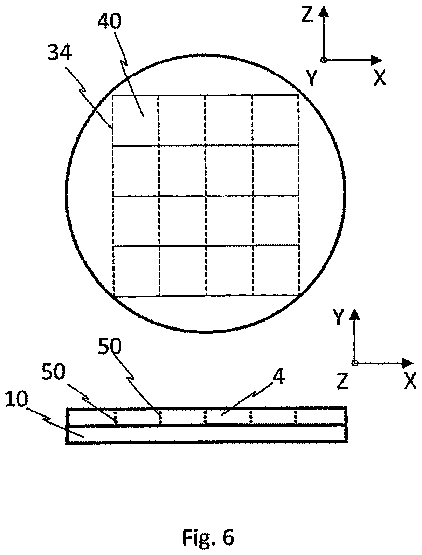

In Fig. 6 ist eine Ausführungsform gezeigt, gemäß der die Festkörperschicht 4 an der Polymerschicht 10 angeordnet ist. Es ist hierbei denkbar, dass die Defekte zum Erzeugen der zweiten Ablöseschicht 50 und der dritten Ablöseschicht 52 bereits in der Festkörperschicht 4 erzeugt sind. Weiterhin ist alternativ denkbar, dass die Defekte zum Erzeugen der zweiten Ablöseschicht 50 und der dritten Ablöseschicht 52 erst nach der Abspaltung der Festkörperschicht 4 von dem Festkörper 2 in der Festkörperschicht 4 erzeugt werden.

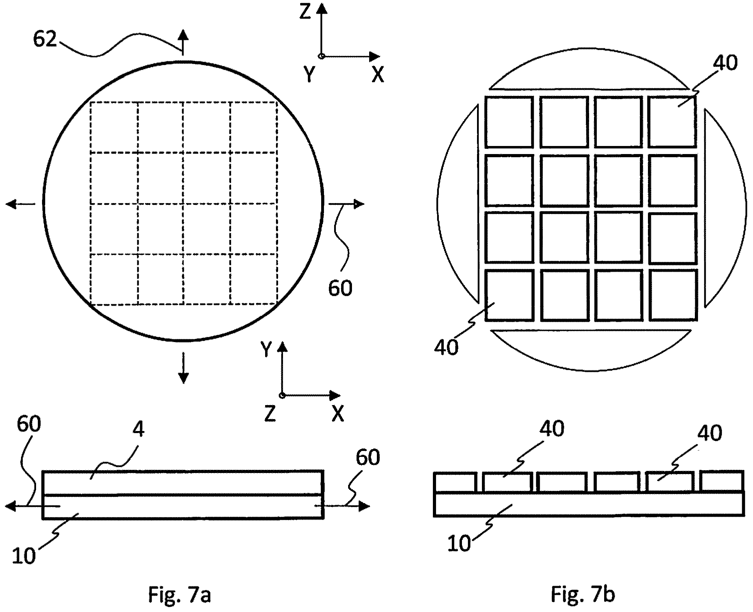

Fig. 7a zeigt eine Anordnung, gemäß der die Festkörperschicht 4 auf der Polymerschicht 10 angeordnet ist bzw. die Festkörperschicht 4 mit der Polymerschicht 10, insbesondere adhäsiv, verbunden ist. Die Polymerschicht 10 wird dabei In einer ersten Richtung 60 und/oder in einer zweiten Richtung 62 ausgelenkt und/oder um mindestens eine Achse gebogen. Die Auslenkung der Polymerschicht 10 kann durch thermische Effekte und/oder äußere Kraftbeaufschlagung, insbesondere Dehnung, Stauchung und/oder Biegung, bewirkt werden.

Als Reaktion auf die bzgl. Fig. 7a beschriebene Auslenkung der Polymerschicht 10, erfolgt ein Ablösen der einzelnen Festkörperelemente 40 im Bereich bzw. entlang der zweiten Ablöseebene 50 und/oder der dritten Ablöseebene 52. Die Ablösung entspricht dabei bevorzugt einem Abbrechen oder Abreisen der einzelnen Festkörperelemente 40 voneinander.

### Bezugszeichenliste

- 2: Festkörper
- 3: Substrat
- 4: Festkörperschicht
- 5: Opferschicht
- 6: Strahlung
- 8: Ablöseebene
- 10: Polymerschicht bzw. Aufnahmeschicht
- 12: Halteschicht
- 14: erster ebener Flächenanteil
- 16: zweiter ebener Flächenanteil
- 18: Strahlungsquelle
- 20: Stabilisierungseinrichtung
- 30: erster Strahlungsanteil
- 32: zweiter Strahlungsanteil
- 34: Ort der Defekterzeugung
- 40: Festkörperelement
- 50: zweite Ablöseebene
- 52: dritte Ablöseebene
- 60: erste Ausdehnung
- 62: zweite Ausdehnung

- X: X-Achse
- Y: Y-Achse
- Z: Z-Achse

## Patentansprüche

1. Verfahren zum Herstellen von Festkörperelementen (40), umfassend die Schritte:
Bereitstellen eines Festkörpers (2),
Erzeugen einer ersten Gruppe von Defekten mittels von einem Laser (18) emittierter Strahlung (6) zum Vorgeben einer ersten Ablöseebene (8), entlang der eine Festkörperschicht (4) vom Festkörper (2) abgetrennt wird,
und **gekennzeichnet durch** folgende Schritte:
Erzeugen einer zweiten Gruppe von Defekten mittels von einem Laser (18) emittierter Strahlung (6) zum Vorgeben von mindestens einer zweiten Ablöseebene (50), wobei die erste Ablöseebene (8) und die zweite Ablöseebene (50) zueinander orthogonal ausgerichtet sind,
Ablösen der Festkörperschicht (4) vom Festkörper (2) entlang der ersten Ablöseebene (8) infolge einer Erzeugung von Spannungen in dem Festkörper (2) und
Teilen der Festkörperschicht (4) entlang der zweiten Ablöseebene (50) zum Vereinzeln der Festkörperelemente (40).

2. Verfahren nach Anspruch 1, wobei
eine dritte Gruppe an Defekten zum Vorgeben einer dritten Ablöseebene (52) mittels von einem Laser (18) emittierter Strahlung (6) erzeugt wird, wobei die dritte Ablöseebene (52) orthogonal zur ersten Ablöseebene (8) und orthogonal zur zweiten Ablöseebene (52) ausgerichtet ist, wobei die Festkörperschicht (4) zum Vereinzeln der Festkörperelemente (40) entlang der zweiten Ablöseebene (50) und entlang der dritten Ablöseebene (52) voneinander getrennt werden.

3. Verfahren nach Anspruch 1 oder Anspruch 2, wobei
die Spannungen zum Ablösen der Festkörperschicht (4) von dem Festkörper (2) durch thermische Beaufschlagung mindestens einer am Festkörper (2) angeordneten Aufnahmeschicht (10), insbesondere einer Polymerschicht, erzeugt werden.

4. Verfahren nach Anspruch 3, wobei
die Aufnahmeschicht (10), insbesondere eine Schicht aus PDMS, zum Erzeugen der Spannungen definiert abgekühlt wird, wobei die Spannungen in dem Festkörper (2) derart erzeugbar sind, dass die Rissauslösung und/oder die Rissausbreitung zum Erzeugen einer vorbestimmten Oberflächenbeschaffenheit der sich in der Rissebene ergebenden Oberfläche steuerbar ist.

5. Verfahren nach einem der vorangegangenen Ansprüche 3 oder 4, wobei
die Aufnahmeschicht (10) derart beaufschlagt wird, dass sie eine Formveränderung in einer ersten Richtung und/oder in einer zweiten Richtung erfährt, wobei eine Formveränderung in der ersten Richtung ein Ablösen von Festkörperelementen (40) voneinander entlang der zweiten Ablöseebene (50) bewirkt und eine Formveränderung in der zweiten Richtung ein Ablösen von Festkörperelementen (40) voneinander entlang der dritten Ablöseebene (52) bewirkt.

6. Verfahren nach Anspruch 5,wobei
die Formveränderung der Aufnahmeschicht (10) in der ersten Richtung und/oder in der zweiten Richtung eine radiale Ausdehnung darstellt, die infolge einer mechanischen Belastung und/oder einer thermischen Beaufschlagung bewirkt wird.

7. Verfahren nach einem der vorangegangenen Ansprüche, wobei
die erste Gruppe von Defekten und die zweite Gruppe von Defekten vor dem Ablösen der Festkörperschicht (4) von dem Festkörper (2) in dem Festkörper (2) erzeugt werden.

8. Verfahren nach einem der vorangegangenen Ansprüche 1 bis 6, wobei
die zweite Gruppe von Defekten nach dem Ablösen der Festkörperschicht (4) von dem Festkörper (2) erzeugt wird.

9. Verfahren nach einem der vorangegangenen Ansprüche,
wobei die erste Ablöseebene (8) in einer zu einer Oberfläche des Festkörpers (2) parallelen Ebene liegt, wobei vom Laser (18) abgegebene Lichtstrahlen (6) durch die zur ersten Ablöseebene (8) parallelen Oberfläche in den Festkörper (2) eindringen.

10. Verfahren nach einem der vorangegangenen Ansprüche,
wobei die Festkörperschicht (4) ein dicker Wafer ist.

## Claims

1. Process for the production of solid-state elements (40), comprising the following steps:
provision of a solid-state body (2),
production of a first group of defects by means of radiation (6) emitted by a laser (18) in order to give a first separation plane (8), along which a solid state layer (4) is separated from the solid state body (2),
and **characterized by** the following steps:
production of a second group of defects by means of radiation (6) emitted by a laser (18) in order to give at least one second separation plane (50), where the first separation plane (8) and the second separation plane (50) are oriented orthogonally in relation to one another,
separation of the solid-state layer (4) from the solid-state body (2) along the first separation plane (8) as a consequence of production of stresses in the solid-state body (2) and
division of the solid-state layer (4) along the second separation plane (50) in order to produce the individual solid-state elements (40).

2. Process according to Claim 1, where
in order to give a third separation plane (52), a third group of defects is produced by means of radiation (6) emitted by a laser (18), where the third separation plane (52) is oriented orthogonally in relation to the first separation plane (8) and orthogonally in relation to the second separation plane (52), where in order to produce the individual solid-state elements (40) the solid-state layer (4) are separated from one another along the second separation plane (50) and along the third separation plane (52).

3. Process according to Claim 1 or Claim 2, where the stresses for the separation of the solid-state layer (4) from the solid-state body (2) are produced by thermal treatment of at least one receptive layer (10) arranged on the solid-state body (2), in particular of a polymer layer.

4. Process according to Claim 3, where the receptive layer (10), in particular a layer made of PDMS, is cooled in defined manner in order to produce the stresses, where the stresses can be produced in the solid-state body (2) in a manner such that the fracture initiation and/or the fracture propagation is/are controllable in order to produce a predetermined surface quality of the surface that arises in the fracture plane.

5. Process according to preceding Claim 3 or 4, where the receptive layer (10) is treated in a manner such that it experiences a shape change in a first direction and/or in a second direction, where a shape change in the first direction brings about separation of solid-state elements (40) from one another along the second separation plane (50) and a shape change in the second direction brings about separation of solid-state elements (40) from one another along the third separation plane (52).

6. Process according to Claim 5, where the shape change of the receptive layer (10) in the first direction and/or in the second direction is a radial expansion which is brought about as a consequence of a mechanical load and/or of a thermal treatment.

7. Process according to any of the preceding claims, where
the first group of defects and the second group of defects are produced in the solid-state body (2) before the separation of the solid-state layer (4) from the solid-state body (2).

8. Process according to any of the preceding Claims 1 to 6, where
the second group of defects is produced after the separation of the solid-state layer (4) from the solid-state body (2).

9. Process according to any of the preceding claims, where the first separation plane (8) lies within a plane parallel to a surface of the solid-state body (2), where light rays (6) emitted by the laser (18) penetrate into the solid-state body (2) through the surface parallel to the first separation plane (8).

10. Process according to any of the preceding claims, where the solid-state layer (4) is a thick wafer.

## Revendications

1. Procédé de fabrication d'éléments (40) de semi-conducteur comprenant les stades :
on se procure un semi-conducteur (2),
on produit un premier groupe de défauts au moyen d'un rayonnement (6) émis par un laser (18), pour la prescription d'un premier plan (8) de détachement, le long duquel on sépare du semi-conducteur (2) une couche (4) de semi-conducteur,
**caractérisé par** les stades suivants :
on produit un deuxième groupe de défauts au moyen d'un rayonnement (6) émis par un laser (18) pour la prescription d'au moins un deuxième plan (50) de détachement, le premier plan (8) de détachement et le deuxième plan (50) de détachement étant orthogonaux l'un par rapport à l'autre,
on détache du semi-conducteur (2) la couche (4) de semi-conducteur le long du premier plan (8) de détachement en raison d'une production de tension dans le semi-conducteur (2) et
on divise la couche (4) de semi-conducteur le long du deuxième plan (50) de détachement, pour l'individualisation des éléments (40) de semi-conducteur.

2. Procédé suivant la revendication 1, dans lequel
on produit au moyen d'un rayonnement (6) émis par un laser (18) un troisième groupe de défauts, pour la prescription d'un troisième plan (52) de détachement, le troisième plan (52) de détachement étant orthogonal au premier plan (8) de détachement et orthogonal au deuxième plan (52) de détachement, dans lequel on sépare la couche (4) de semi-conducteur pour l'individualisation des éléments (40) de semi-conducteur le long du deuxième plan (50) de détachement et le long du troisième plan (52) de détachement les uns des autres.

3. Procédé suivant la revendication 1 ou 2, dans lequel
on produit des tensions pour détacher la couche (4) de semi-conducteur du semi-conducteur (2), en soumettant à la température au moins une couche (10) de réception, notamment une couche de polymère, disposée sur le semi-conducteur (2).

4. Procédé suivant la revendication 3, dans lequel
on refroidit d'une manière définie la couche (10) de réception, notamment une couche en PDMS, pour la production des tensions, les tensions dans le semi-conducteur (2) pouvant être produites de manière à pouvoir commander le déclenchement d'une fissure et/ou la propagation d'une fissure pour la production d'une propriété de surface déterminée à l'avance de la surface se créant dans le plan de la fissure.

5. Procédé suivant l'une des revendications 3 ou 4 précédentes, dans lequel
on soumet la couche (4) de réception à une température de manière à lui faire subir une modification de forme dans une première direction et/ou dans une deuxième direction, une modification de forme dans la première direction provoquant un détachement d'éléments (40) de semi-conducteur les uns des autres le long du deuxième plan (50) de détachement et une modification de forme dans la deuxième direction provoquant un détachement d'éléments (40) de semi-conducteur les uns des autres le long du troisième plan (52) de détachement.

6. Procédé suivant la revendication 5, dans lequel la modification de forme de la couche (10) de réception dans la première direction et/ou dans la deuxième direction représente un allongement radial, qui est provoqué en raison d'une charge mécanique et/ou d'une soumission à la température.

7. Procédé suivant l'une des revendications précédentes, dans lequel
on produit le premier groupe de défauts et le deuxième groupe de défauts dans le semi-conducteur (2) avant de détacher la couche (4) de semi-conducteur du semi-conducteur (2).

8. Procédé suivant l'une des revendications 1 à 6 précédentes, dans lequel
on produit le deuxième groupe de défauts après avoir détaché la couche (4) de semi-conducteur du semi-conducteur (2).

9. Procédé suivant l'une des revendications précédentes,
dans lequel le premier plan (8) de détachement est dans un plan parallèle à une surface du semi-conducteur (2), des rayons (6) lumineux émis par le laser (8) pénétrant dans le semi-conducteur (2) par la surface parallèle au premier plan (8) de détachement.

10. Procédé suivant l'une des revendications précédentes,
dans lequel la couche (4) de semi-conducteur est une tranche épaisse.
